# EUROPEAN PATENT APPLICATION

(11) **EP 1 345 297 A1**
(43) Date of publication of application: **17.09.2003**
(21) Application number: 02251897.1
(22) Date of filing: 16.03.2002
(51) Int. Cl.: H01S 5/0687

(54) **An arrangement for monitoring the emission wavelength and power of an optical source**

(71) Applicant: Agilent Technologies, Inc. (a Delaware corporation), Palo Alto, CA 94303 (US)
(72) Inventor: Lano, Roberto, 10040 Almese (IT); Delpiano, Franco, 0093 Collegno (IT)
(74) Representative: Coker, David Graeme

(57) **Abstract**

An arrangement for monitoring the main radiation beam emitted by an optical source such as a laser diode (10) having a nominal emission wavelength, includes first (18) and second (20) photodetectors as well as a wavelength selective element (22). A beam splitter module (16) is provided for splitting a secondary beam from the main radiation beam of the laser source and directing it towards the first (18) photodetector via the associated wavelength selective element (22). The wavelength selective element (22) has a wavelength selective transmittance-reflectance characteristic, whereby said secondary beam is partly propagated towards said first (18) photodetector and partly reflected from said wavelength selective element (22) towards the second (20) photodetector. The output signals (18a, 20a) from the photodiodes (18, 20) have intensities whose behaviours as a function of wavelength are complementary to each other. Signal processing circuitry (32) is further provided including an adder module (26) and subtractor module (28) fed with the output signals from the photodiodes 818, 20) to generate:
- a wavelength-independent sum signal (26a; αA1+βB1), indicative of the intensity of the optical radiation generated by the optical source (10), and
- a wavelength-dependent difference signal (28a; α'A1-β'B1), indicative of the difference between the actual wavelength of the radiation generated by said optical source (10) and its nominal emission wavelength.

## Description

The invention relates to arrangements for monitoring the emission wavelength and power of optical sources such as laser sources.

Commercial WDM (Wavelength Division Multiplex) transmission systems, such as "dense" WDM (DWDM) systems provide high transmission capacity by using reduced channel spacing (e.g. 100-50 GHz). Real time monitoring and control is thus necessary in order to ensure the stability required for the optical sources used in such systems.

A number of devices adapted for that purpose (and primarily for wavelength monitoring) are based on the arrangement currently referred to as "wavelength locker". This usually consists of two photodiodes sampling two portions of the optical beam (typically a laser beam). One of the photodiodes, used as a reference, samples an unfiltered portion of the laser beam. Another portion of the laser beam is passed through an optical filter and caused to impinge onto the second photodiode. The response (i.e. the photocurrent) of the first diode is thus indicative of the power emitted by the optical source; the response of the second diode is a function of the possible displacement of the actual wavelength of the beam generated by the laser source with respect to the wavelength of the filter.

A beam splitter is used to split the laser beam into a main beam to be used for the intended application (e.g. for launching into a fiber) and one or more secondary beam or beams to be directed towards the photodiodes of the locker arrangement.

Various arrangements are known in order to effect stabilisation. For instance, in the case of diode lasers, a Peltier element can be used as a wavelength stabilising element by controlling the temperature of the laser diode, while power stabilisation is effected by controlling the laser bias current.

Arrangements of the general type referred to in the foregoing, or substantially similar thereto, are disclosed e.g. in US-A-5 825 792 and US-A-6 094 446.

Specifically, the arrangement of US-A-5 825 792 comprises a narrow bandpass, wavelength selective transmission filter element, of Fabry-Perot etalon structure, through which a non-collimated beam from a laser source is directed onto two closely spaced photodetectors. For wavelength stabilisation, the differential output of the two photodetectors is used in a feedback loop to stabilise the wavelength of the laser source to a desired target wavelength. Through the angular dependence of wavelength transmission of the Fabry-Perot etalon, the wavelength variation from the source is converted to a transmission loss, which is different for the two photodetectors, so that the wavelength change is detected as a differential power change. The device functions as an optical wavelength discriminator in which the detectors convert optical energy to current for a feedback loop for controlling the light source. A lens may be used to control the divergence of the light incident on the filter element to optimise power transfer. Optionally, wavelength tunability is provided by changing the angle of inclination of the Fabry-Perot etalon relative to the laser source.

In the arrangement of US-A-6 094 146 the light emitted by a laser diode is propagated towards an interference optical filter. Light passing through the filter and the light reflected therefrom are caused to impinge onto two photodiodes to generate respective output signals. The ratio of those signals is calculated in an arrangement including an adder, a subtractor and a divider. The arrangement further includes an error detector adapted to detect the difference between the output ratio and a reference value. The emission wavelength of the laser diode is controlled in such a way that the error signal may be equal to zero.

A number of factors must be taken into account in applying such arrangements in order to produce compact stabilised optical sources.

Generating optical signals proportional to the optical power and wavelength of a laser source almost invariably requires the radiation from the laser source to be split over distinct propagation paths. This may turn out to be a fairly critical solution, especially when the laser beam emitted from the back facet of the laser is exploited for stabilisation purposes as an alternative to splitting a fraction of the main beam generated from the front facet of the laser. In order to collect sufficient power, the light signal must be collimated into a low-divergence beam by using a lens. This arrangement necessitates a critical active alignment step, as recognised e.g. in K. Anderson, IEEE Electronic Component and Technology Conference, 1999, pp. 197-200.

The object of the present invention is thus to provide an improved arrangement overcoming the drawbacks of the solution of the prior art considered in the foregoing.

According to the present invention, that object is achieved by means of arrangement having the features set forth in the claims which follow.

Essentially, the presently preferred embodiment of the invention consists of a combined power and wavelength control system based on marginal splitting of the principal radiation emitted by the optical source through a wavelength selective element such as an interference or an etalon filter. The filter provides transmitted and reflected radiations (with intensities having complementary behaviours to each other as a functions of wavelength). Error signals are thus detected and used for feedback control of wavelength and power stability. The optical filter is usually deposited on a glass slice or directly on a surface of a cube beam splitter. The optical filter can be mounted together with the optical source (typically a laser diode), the photodetectors, the temperature sensor and the optical components on a small Silicon Optical Bench (SiOB) substrate to achieve good thermal and mechanical performance.

The arrangement of the invention permits compact wavelength and power control systems to be implemented which do not require critical active alignment of the optical components. The arrangement of the invention is thus ideally suited for high volume production at low cost. Moreover, the system of the invention uses for both power and wavelength control only a small fraction of the optical output signal generated from the optical source. Optimal consistency and stability can be attained with signals adapted for electronic processing (sum, differentiation, etc.) and the sensitivity/resolution performance of the control system is improved. Furthermore, the arrangement of the invention exploits only the front side beam generated from the front facet or area of the laser source, whereby the back area of the respective semiconductor chip is left free and available e.g. for short RF connections.

The arrangement of the invention will now be described, by way of example only, with reference to the annexed figures of drawing, wherein:
- Figure 1 is a schematic representation of an optical arrangement according to the invention,
- Figure 2 shows in detail the overall structure of the arrangement of figure 1, including the electronic functions for the feedback control.
- Figure 3 shows in still further detail some of features of the elements shown in figure 2,
- Figure 4 illustrates various processing steps performed in a system according to the invention, and
- Figure 5 includes three superposed diagrams indicated a), b), and c) that illustrate typical behaviours of signals generated within an arrangement according to the invention.

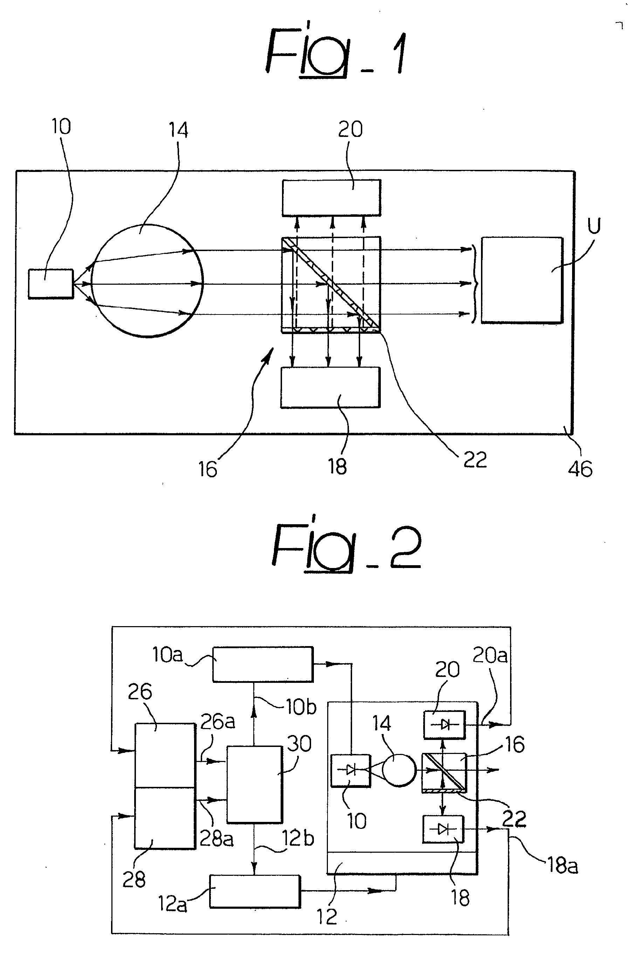

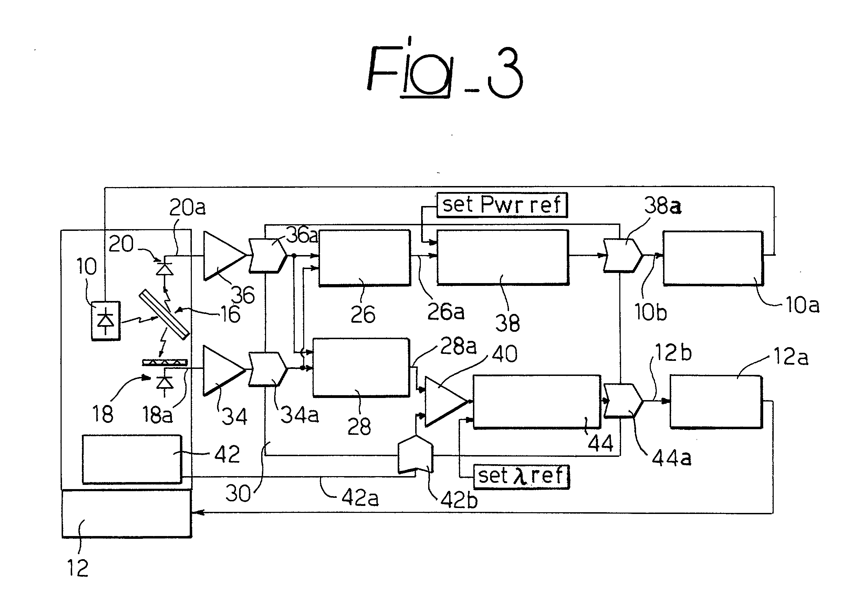

In the diagrams of figures 1 to 3, reference 10 indicates an optical source represented, in a typical embodiment of the invention, by a laser diode. Laser source 10 has associated therewith a temperature regulating element 12 such as a Peltier thermoregulator driven by a control unit 12a having an input control line 12b.

Automatic power control of laser source 10 is accomplished by controlling the laser bias current through a current drive unit 10a having an input line 10b.

The arrangement of parts just described, and the principles of operation thereof, are well known to those skilled in the art, thus making it unnecessary to provide a more detailed description herein.

Associated with the (front) main output facet of laser source 10 is a lens 14 which collimates the beam emitted by laser source 10 through a partial (few per cent) reflective beam splitter 16.

Preferably, beam splitter 16 is a cube beam splitter arranged to propagate a main radiation beam coming from the collimating optics (i.e. lens 14) towards a "output" unit U. This is typically an optical arrangement providing a wavelength and power controlled output to an external user (not shown).

Beam splitter 16 deflects a part of the radiation received from lens 14 towards a wavelength selective optical filter 22 having a slope characteristic centered around the nominal emission wavelength of laser source 10 at a specific temperature.

Typically, optical filter 22 is an interference filter having a transmission/reflection characteristic which is continuously variable as a function of wavelength in a specific range, with a specific slope at a specific temperature. Thus, the light signal coming from source 10 is deflected by the semireflective surface of beam splitter 16 towards filter 22.

The portion of light transmitted through optical filter 22 is detected by a photodetector such as a photodiode 18.

The portion of light reflected (i.e. not transmitted) by optical filter 22 is propagated back through the partial reflective surface of beam splitter 16 towards another photodetector/photodiode 20.

Beam splitter 16 is preferably in the form of a cube beam splitter having a main diagonal semireflective face arranged to lie in a plane at 45° with respect to both to the direction of propagation of the main radiation beam from source 10 to the "output" unit U and the direction(s) of propagation of the deflected radiation towards both photodiodes 18 and 20.

In the exemplary arrangement shown herein, the radiation impinging onto second photodiode 20 is not derived directly (by beam splitting) from the main radiation beam generated from the laser source 10. In fact, when crossing beam splitter 16, the radiation from laser source 10 (and lens 14) is - mostly - propagated in the form of a main output beam towards the "output" unit U, while a fraction (a few per cent) is deviated towards photodetector 18 in the form of a secondary split beam. Such secondary beam is propagated towards photodetector 18 via wavelength-selective filter 22 and the portion of the secondary beam which is reflected from filter 22 produces a "third" optical beam. Such a third optical beam then impinges onto photodiode 20 after having further crossed beam splitter 16.

The output signals emitted by photodetectors 18 and 20 are fed over respective output lines 18a, 20a to sum/difference determination blocks 26, 28, included in a microcontroller block 30.

Blocks 26 and 28 generate respective output signals on output lines 26a, 28b.

These output signals correspond to:
- a (preferably weighed) sum of the output signals (currents) generated by photodetectors 18 and 20, and
- a (preferably weighed) difference of the currents generated by the same photodetectors.

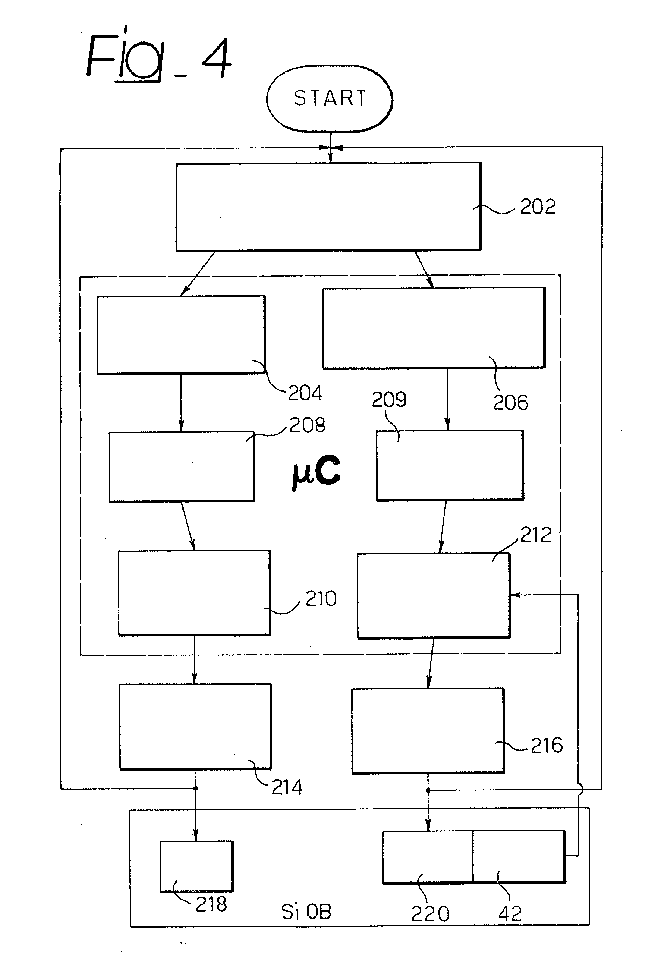

More specifically, in the block diagram of figure 3 references 34 and 36 indicate two transimpendance amplifiers (TIA) that receive the output currents from photodiodes 18 and 20. After conversion from analog to digital performed in A/D converters designated 34a and 36a, the output (photo) currents A1, B1 from photodiodes 18 and 20 are fed to adder and subtractor blocks 26 and 28.

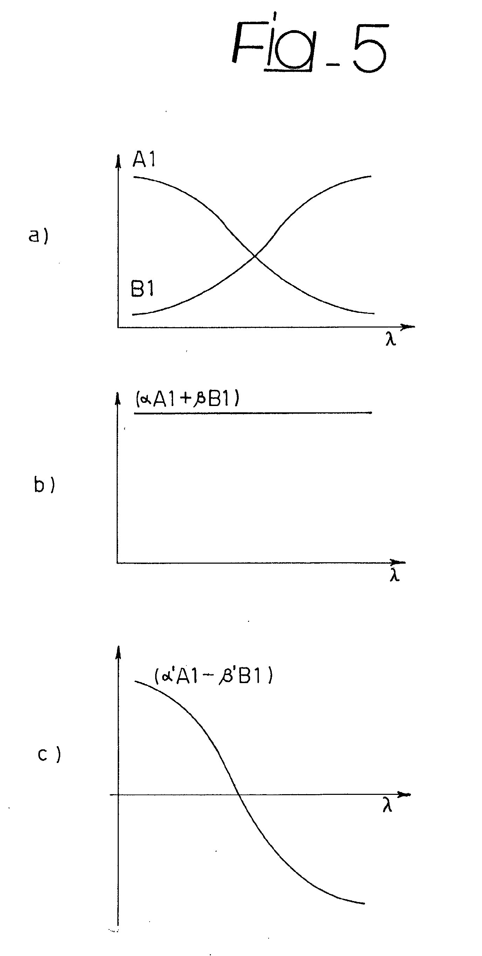

Due to the arrangement of parts just described (and primarily the transmission/reflection characteristic of filter 22) the output currents A1, B1 on lines 18a, 20a exhibit intensities vs. wavelength curves that are complementary to each other as shown in diagram a) of Figure 5.

The signal on output line 26a thus corresponds to the a sum of the photocurrents A1, B1 generated by photodetectors 18 and 20 weighed through suitable parameters α and β to make it indicative of the optical power emitted by laser source 10 in a manner which is totally independent of wavelength: see diagram b) in Figure 5.

The output signal from adder block 26 on line 26a is used to control the laser diode current driver unit 10a by acting on line 10b. This is done by subjecting the output signal from adder block 26 on line 26a to the action of a controller such as PID (Proportional-Integral-Derivative) controller 38 included in microcontroller 30. The output signal from controller 38 is back-converted into the analogue domain in a D/A converter 38a whose output is fed as a control signal to the laser diode controller 10a.

The output signal from subtractor block 28 on line 28a corresponds to the difference of the photocurrents A1, B generated by photodetectors 18 and 20 (correlated by a complementary wavelength dependence thanks to the action of optical filter 22) as shown in diagram c) in Fig. 5.

Again, the output signal from subtractor block 28 on line 28a may be weighed through suitable factors α' and β', and is in any case indicative of the actual emission wavelength of laser source 10 i.e. the "difference" or "distance" of the actual emission wavelength of laser source to the nominal expected emission wavelength

The output signal from subtractor block 28 on line 28a is preferably subjected to a scaling/normalisation action in a further amplifier 40. This is done as a function of an "ambience" signal provided on a line 42a by a thermal sensor 42 sensitive to the temperature of the laser diode 10 and the optical filter22 in order to avoid undesired temperature-induced performance variations over time. Again, before being fed to amplifier 40, the signal from temperature sensor 42 on line 42a is converted to the digital format in an A/D converter 42b.

The scaled/normalised signal leaving amplifier 40 is then used to control, via another PID controller designated 44 and an associated output D/A converter 44a, the Peltier driver 12a that ensures wavelength stabilisation of laser diode 10 via temperature regulation.

As indicated (see figure 1), the whole of laser source 10, collimating optics 14, and beam splitter/filter arrangement 16, 22 are preferably arranged onto a single Silicon Optical Bench (SiOB) 46.

Similarly, the various modules/components designated 26, 28, 34a, 36a, 38, 38a, 40, 42b, 44, 44a, can be advantageously integrated to a single microcontroller 30.

The sequence of operation of such a microprocessor is portrayed in the flow diagram of figure 4.

After a start phase or step 200, in a step 202 the output signals A1, B1 from photodiodes 18 and 20 are read to be subsequently summed (in adder 26 - step 204) or subtracted from each other (in subtractor 28 - step 206).

The sum signal obtained in step 204 is then compared in a step 208 to a given power reference value to be then fed to PID controller 38 in step 210.

Similarly, in a step 209, the difference signal obtained in step 206 is compared to a respective wavelength reference value to be fed to PID controller 44 in step 212. Preferably the wavelength reference value is set to zero.

The control signals generated by PID controllers 38 and 44 are sent towards the laser diode current driver (step 214) and the Peltier driver (step 216). Corresponding control signals are then sent (steps 218, 220) towards the elements effecting output power stabilisation (by varying the laser bias current) and wavelength stabilisation (via the Peltier thermoregulator 12).

The stabilisation process described is repeated cyclically as indicated by the return lines from steps 214 and 216 towards step 202.

Assuming that the output signals from photodiodes 18 and 20 are designated A1, B1, respectively, the output signals from adder 26 and subtractor 28 can be expressed as:
- αA1 + βB1 and
- α'A1 - β'B1,
respectively.

The sum/difference operations - being performed digitally within a microcontroller - can be implemented with a high degree of accuracy, also as regards the multiplying coefficients α and β applied to signals A1 and B1. In the case coefficients α' and β' can be exactly adjusted in digital form in order to ensure that the difference α'A1-β'B1 is equal to zero when the wavelength of the radiation emitted from laser source 10 exactly equals the nominal desired value of the emission wavelength.

Naturally, the principles of the invention remaining the same, the details of construction and the embodiments may widely vary with respect to what has been described and illustrated purely by way of example, without departing from the scope of the present invention as defined by the annexed claims. Finally, it will be appreciated that terms such as "optical", "light", "photosensitive", and the like are used herein with the meaning currently allotted to those terms in fiber and integrated optics, being thus intended to apply to radiation including, in addition to visible light, e.g. also infrared and ultraviolet radiation.

## Claims

**1.** An arrangement for monitoring the main radiation beam emitted by an optical source (10) having a nominal emission wavelength, the arrangement including first (18) and second (20) photodetectors as well as a wavelength selective element (22), said first (18) and second (20) photodetectors being adapted to be exposed to said radiation beam to generate respective first (18a, A1) and second (20a, B1) output signals, **characterised in that**:
- the arrangement further includes a beam splitter module (16) for splitting a secondary beam from said main radiation beam and directing said secondary beam towards said first (18) photodetector via said associated wavelength selective element (22),
- said wavelength selective element (22) has a wavelength selective transmittance-reflectance characteristic, whereby said secondary beam is partly propagated towards said first (18) photodetector and partly reflected from said wavelength selective element (22) towards said second (20) photodetector, whereby said first (A1) and second (B1) output signals have intensities whose behaviours as a functions of wavelength are complementary to each other, and
- signal processing circuitry (32) is provided including adder (26) and subtractor (28) modules fed with said first (A1) and second (B1) output signals to generate:
- a wavelength-independent sum signal (26a; αA1+βB1), indicative of the intensity of the optical radiation generated by said optical source (10), and
- a wavelength-dependent difference signal (28a; α'A1-β'B1), indicative of the difference between the actual wavelength of the radiation generated by said optical source (10) and said nominal emission wavelength.

**2.** The arrangement of claim 1, **characterised in that** said wavelength selective element (22) has a transmission/reflection characteristic which is continuously variable as a function of wavelength in a specific wavelength range.

**3.** The arrangement of either of claim 1 or claim 2, **characterised in that** it includes a drive unit (10a) for controlling the intensity of the radiation emitted by said optical source (10) and **in that** said drive unit (10a) is arranged to control the intensity of the optical radiation generated by said optical source (10) by comparing said sum signal (αA1+βB1) to a reference settable value.

**4.** The arrangement of any of claims 1 to 4, **characterised in that** it includes a regulator unit (12) for controlling the wavelength of the radiation emitted by said optical source (10) and **in that** said regulator unit (12) is arranged to control the wavelength of the optical radiation generated by said optical source (10) by comparing said difference signal (α'A1-β'B1) to a reference settable value.

**5.** The arrangement of any of the previous claims, **characterised in that** it includes a temperature sensor (42) for sensing the temperature of at least one of said optical source (10) and said wavelength selective element (22 as well as a module (12) for conditioning the temperature of said optical source (10) as a function of said difference signal (28a; α'A1-β'B1).

**6.** The arrangement of claim 5, **characterised in that** said temperature conditioning module is in the form of Peltier module.

**7.** The arrangement of any of the previous claims, further including said optical source (10).

**8.** The arrangement of any of the previous claims, **characterised in that** said optical source (10) is a laser diode.

**9.** The arrangement of any of the previous claims, **characterised in that** it includes a silicon optical bench (SiOB) hosting at least one of said optical source (10), said beam splitter (16), and said first (18) and second (20) photodiodes.

**9.** The arrangement of any of the previous claims, **characterised in that** said wavelength selective element (22) is an optical interference filter or an etalon filter.

**10.** The arrangement of any of the previous claims, **characterised in that** it includes an optical system (14) for directing said main radiation beam onto said beam splitter (16).

**11.** The arrangement of claim 10, **characterised in that** said optical system includes a lens or lens system (14).

**12.** The arrangement of any of the previous claims, **characterised in that** it includes at least one controller module (38, 44) for controlling at least one of the power and the wavelength of said radiation beam as a function of at least one of said sum signal (26a) and difference signals (28a).

**13.** The arrangement of claim 12, **characterised in that** it includes a first controller module (38) for controlling the power of said radiation beam as a function of said sum signal (26a) as well as a second controller module (44) for controlling the wavelength of said radiation beam as a function of said difference signal (28a).

**14.** The arrangement of either of claims 12 or 13, **characterised in that** said at least one controller module (38, 44) is a PID controller.

**15.** The arrangement of any of the previous claims, **characterised in that** it includes at least one analog-to-digital converter (34a, 36a) for converting said first (18a, A1) and second (20a, B1) output signals into digital signals before feeding said first and second output signals (18a, 20a) to said adder (26) and subtractor (28) modules .

**16.** The arrangement of claim 15, **characterised in that** it includes at least one digital-to-analog converter (38a, 44a) to convert said sum (26a) and difference (28a) signals into analog signals.
